Europäisches Patentamt

European Patent Office

Office européen des brevets

(19)

(11) **EP 1 200 845 B1**

(12) **FASCICULE DE BREVET EUROPEEN**

(45) Date de publication et mention
de la délivrance du brevet:
**17.11.2004 Bulletin 2004/47**

(51) Int Cl.⁷: **G01R 29/10**

(21) Numéro de dépôt: **00956605.0**

(86) Numéro de dépôt international:
**PCT/FR2000/002231**

(22) Date de dépôt: **02.08.2000**

(87) Numéro de publication internationale:
**WO 2001/009626 (08.02.2001 Gazette 2001/06)**

(54) **PROCEDE ET DISPOSITIF DE MESURE EN CHAMP PROCHE DE RAYONNEMENTS RADIOELECTRIQUES NON CONTROLES**

VERFAHREN UND VORRICHTUNG ZUR NAHFELDMESSUNG UNKONTROLLIERTER ELEKTROMAGNETISCHER ABSTRAHLUNGEN

METHOD AND DEVICE FOR NEAR-FIELD MEASURING OF NON-CONTROLLED RADIATION

(84) Etats contractants désignés:
**DE GB IT**

(30) Priorité: **03.08.1999 FR 9910213**

(43) Date de publication de la demande:
**02.05.2002 Bulletin 2002/18**

(73) Titulaire: **FRANCE TELECOM**
**75015 Paris (FR)**

(72) Inventeurs:
 • **FOURESTIE, Benoît**
  **F-75014 Paris (FR)**
 • **ALTMAN, Zwi**
  **F-92320 Châtillon (FR)**
 • **WIART, Joe**
  **F-77400 Lagny (FR)**
 • **GRANDSIMON, Gérard**
  **F-92140 Clamart (FR)**
 • **BOLOMEY, Jean-Charles**
  **F-75013 Paris (FR)**

(74) Mandataire: **Vidon, Patrice**
**Cabinet Vidon**
**16 B, rue Jouanet - B.P. 90333**
**35703 Rennes Cedex 7 (FR)**

(56) Documents cités:
**DE-A- 19 807 208**

• RUOSS H O ET AL: "EMC-INVESTIGATION OF HAND-HELD MOBILE TELEPHONES USING A DOUBLE- CONE NEARFIELD TO FARFIELD TRANSFORMATION" PROCEEDINGS OF THE EUROPEAN MICROWAVE CONFERENCE,GB,SWANLEY, NEXUS MEDIA, vol. CONF. 26, 1996, pages 795-798, XP000682639 ISBN: 1-899919-08-2
• YAHYA RAHMAT-SAMII ET AL: "THE UCLA BI-POLAR PLANAR-NEAR-FIELD ANTENNA-MEASUREMENT AND DIAGNOSTICS RANGE" IEEE ANTENNAS AND PROPAGATION MAGAZINE,US,IEEE INC, NEW YORK, vol. 37, no. 6, 1 décembre 1995 (1995-12-01), pages 16-35, XP000552175 ISSN: 1045-9243
• LAURIN J -J: "NEAR-FIELD CHARACTERIZATION OF PCBS FOR RADIATED EMISSIONS PREDICTION" PROCEEDINGS OF THE INTERNATIONAL SYMPOSIUM ON ELECTROMAGNETIC COMPATIBILITY,US,NEW YORK, IEEE, vol. -, 1993, pages 322-326, XP000427692
• D.S RAFIN ET AL.: "Sperical Near-Field Facility for Microwave Coupling Assessments in the 100MHz-6GHz Frequency Range" IEEE TRANSACTIONS ON ELECTROMAGNETIC COMPATIBILITY, vol. 40, no. 3, août 1998 (1998-08), pages 225-234, XP002136104 US cité dans la demande

• ROCZNIAK A ET AL: "3-D ELECTROMAGNETIC FIELD MODELING BASED ON NEAR FIELD MEASUREMENTS" PROCEEDINGS OF THE INSTRUMENTATION AND MEASUREMENT TECHNOLOGY CONFERENCE (IMTC),US,NEW YORK, IEEE, 1996, pages 1124-1127, XP000852501 ISBN: 0-7803-3313-6 cité dans la demande

## Description

Le domaine de l'invention est celui des systèmes de mesure du champ électrique émis par un équipement électronique quelconque.

Les champs rayonnés par un équipement électronique, que l'on désignera également par la suite sous l'acronyme « AST », pour « Appareil Sous Test », peuvent être différenciés en rayonnements intentionnels, recherchés et inhérents à son fonctionnement, et en rayonnements non intentionnels.

Ainsi, un radiotéléphone mobile émet-il un rayonnement attendu, nécessaire à la communication, ainsi que le cas échéant des rayonnements complémentaires parasites, non intentionnels. Un ordinateur de table, et notamment son écran de visualisation, émettent généralement des rayonnements non intentionnels.

Les rayonnements non intentionnels peuvent être répartis en émissions utiles, c'est à dire porteuses d'information signifiante, et en émissions non utiles (bruits).

A un moment où les systèmes de télécommunication connaissent une extraordinaire expansion, la meilleure appréhension des rayonnements émis est rendue primordiale par la nécessité de garantir une certaine qualité de service et une meilleure sécurisation des informations.

Ainsi, à titre d'exemple, la mesure précise de ces différents signaux est indispensable pour des applications diverses, dont notamment :

- la prévision de la couverture radioélectrique ;
- la vérification de la Compatibilité Electromagnétique (CEM) et la conformité aux normes ;
- le durcissement et la sécurisation, c'est à dire en particulier le contrôle et la diminution des signaux utiles émis ;
- l'analyse de l'interaction des ondes électromagnétique avec les personnes.

La mesure de ces différents signaux est extrêmement difficile à mettre en oeuvre en utilisant les techniques de mesure actuelles. Comme on le verra plus loin, ces mesures s'avèrent en outre d'autant plus malaisées que l'on ne maîtrise pas l'alimentation des équipements concernés.

On connaît plusieurs techniques de mesures des rayonnements émis par des appareils.

Afin de limiter les émissions de signaux non intentionnel, des organismes normatifs internationaux compétents en CEM, tels que le CISPR (International Special Committee on Radio Interference, que l'on pourrait traduire en français par Comité International Spécial sur les Interférences Radio) ou l'ANSI (American National Standards Institute, à savoir l'Institut National de Normalisation des Etats Unis d'Amérique), ont établi des recommandations et mis en place des niveaux de rayonnements non intentionnels maximaux pour un AST dans une configuration donnée, de 30 MHz à 1 GHz. Les méthodes de mesure de champ parasite rayonné par un AST sont spécifiés dans le document normatif du CISPR 16-1, 1993 « Spécifications des méthodes et des appareils de mesure des perturbations radioélectriques et de l'immunité au perturbations radioélectriques », ou encore dans le document de l'ANSI C63.4-1988 « American national standard : Methods of measurements of radio noise emissions from low voltage electrical and electronic equipment in the range of 10 kHz to 1 GHz, en français : méthodes de mesure des émissions de bruit radio par des équipements électriques et électroniques à faible tension dans le domaine de 10 kHz à 1 GHz ». Ces documents spécifient des mesures en espace libre au-dessus d'un plan parfaitement conducteur.

Le protocole de mesure recommandé par le CISPR présente de sérieux inconvénients :

- A basse fréquence, les hypothèses de champ lointain utilisées sont source d'erreurs.
- L'antenne de mesure se trouve dans la zone de Fresnel (champ proche) de l'AST et la structure des ondes rayonnées n'est pas une structure d'ondes planes contrairement à l'approximation effectuée
- Des phénomènes de couplage difficiles à prendre en compte, et susceptibles d'affecter la validité de la mesure, peuvent se produire entre l'AST et l'antenne de mesure, ou bien entre l'antenne et son image sur le sol, et entraîner une modification de la valeur du facteur d'antenne.
- La méthode ne permet pas, à cause de la troncature angulaire en hauteur et de l'influence du sol, de donner un diagramme précis du rayonnement de l'AST, ni de caractériser les signaux émis.
- Les mesures sont fastidieuses à réaliser, car elles supposent un balayage en fréquence de toute la bande considérée.
- Enfin, ces mesures sont spécifiées sur des sites de mesures normalisés que peuvent être des sites en espace libre (Open Area Test Site) ou des chambres semi anéchoïques. Ces sites doivent être de très grande taille, sont souvent onéreux et peu pratiques, et sont sujets à des imperfections nombreuses : émissions parasites, phénomènes atmosphériques perturbants, ou encore mauvaises performances des absorbants, défauts de blindage, etc.

On a également développé des techniques de mesures en champ proche (CP) dont le principe suppose que l'alimentation de l'AST soit maîtrisée (voir J. Ch. Bolomey et al. « Spherical near-field facility for microwave coupling assessment in the 100 MHz-4 GHz frequency range (dispositif sphérique en champ proche pour la mesure de couplage en hyperfréquence dans le domaine de fréquence de 100 MHz à 4 GHz) » in IEEE Trans. Antennas Propagat., vol. 40, pp. 225-234, Août 1998). Selon cette technique, des mesures ont été réalisées en remplaçant l'alimentation de l'appareil étudié par une alimentation contrôlée. Dans ce cas, le champ rayonné par l'AST modifié peut être mesuré à faible distance en amplitude et en phase. Cette mesure est effectuée en corrélant le signal de l'alimentation au signal mesuré en un point. Le champ en tout point de l'espace peut donc être calculé à toute distance en utilisant les techniques connues de transformation CP - Champ Lointain (CL).

Toutefois, il est clair que dans cette configuration de mesure, l'appareil ne se trouve pas dans ses conditions normales d'utilisation, puisque son alimentation reste contrôlée. La validité de ce type de mesure est, de ce fait, limitée aux conditions de mesure (voir à ce sujet J. Hald et al., « Spherical near field measurements (mesures sphériques en champ proche) », Peter Peregrinus, Grande Bretagne, 1998).

Il reste certes possible de réaliser des mesures sans maîtriser la source, mais l'opération de corrélation mentionnée ci-dessus ne peut alors être effectuée et les mesures en CP sont réalisées en amplitude seulement. La répartition de champ proche est alors connue à la seule distance de mesure ce qui ne permet pas de déterminer la puissance totale émise. Pour ce faire, il faudrait encore mesurer le champ en amplitude sur une surface entourant l'AST et située en champ lointain de dernier. Ces mesures sont difficiles et coûteuses à mettre en oeuvre.

Une telle méthode de mesure du champ proche rayonné par un AST dont on ne maîtrisait pas l'alimentation a été présentée dans A. Roczniac et al., « 3-D Electromagnetic Field Modeling Based on Near Field Measurements (Modélisation 3-D du champ magnétique basée sur des mesures en champ proche) » in IEEE Conf. on Instruments and measurements, Bruxelles, Helgique, 1996. Cette méthode consiste à mesurer le champ électrique en amplitude seulement sur deux hémisphères concentriques. A l'aide d'un algorithme de minimisation, la phase est recalculée sur un des deux hémisphères. Cependant cette méthode n'a, selon les auteurs, pas permis de donner des bornes fiables de champ électrique rayonné à toute distance de l'AST.

Le document "EMC - investigation of hand-held mobile telephones using a double-cone nearfield to farfield transformation" par RUOSS et al (proceedings of the European Microwave Conference, GB, Swanley, Nexus Media, vol. Conf 26, 1996, pp 795-796) présente une autre utilisation des mesures en champ proche, visant à mesurer l'influence du corps humain sur les performances d'un téléphone portable, mais qui ne permet la mesure du rayonnement émis par l'appareil.

On connaît encore, par le document "The UCLA bi-polar planar-new-field antenna measurement und diagnostic range" par RAHMAT-SAMII et al (IEEE Antennas and propagation magazine, US, IEEE INK, New-York, vol. 37, n°6, déc. 1995, pp 16-35) une méthode de mesure d'antenne bipolaire basé sur une mesure de champ proche plane. Cette technique ne s'applique qu'à des mesures dans un plan.

Enfin, une nouvelle méthode de traitement de données de mesure, ci-après dénommée pour simplifier la méthode FBAB — acronyme formé des initiales du nom des inventeurs -, a été proposée par les inventeurs de la présente demande de brevet dans « Extension des techniques de mesure en champ proche à la caractérisation de systèmes rayonnants complexes en régime aléatoire », in Journées nationales micro-ondes, Arcachon, France, Mai 1999. Dans cet exposé théorique, il est implicitement admis, de façon évidemment fictive, que les signaux sont mesurés simultanément en tous les points de mesure de la surface considérée. Il est théoriquement possible en mettant en oeuvre cette méthode de traitement de connaître toutes les grandeurs utiles mentionnées précédemment. Mais cette hypothèse de mesure simultanée en tous points de la surface n'est pas réaliste car la complexité de l'appareillage de mesure nécessaire serait rédhibitoire.

On connaît enfin des techniques de mesures développées en chambres réverbérantes, dont le principe est le suivant : l'AST est placé dans une enceinte à géométrie variable au cours du temps, et à parois parfaitement conductrices. On montre alors que, à certaines conditions près, on peut mesurer en tout point de la cavité la puissance moyenne totale rayonnée par l'AST (voir J. Page « Stirred mode reverberation chambers for EMC measurements and radio type approvals » IEE, 1998). Cette méthode de mesure n'est toutefois pas encore complètement maîtrisée et de grandes précautions doivent être prises lors de la mesure de systèmes fortement dispersifs. En raison des multiples réflexions, la mesure du diagramme de rayonnement de l'AST ainsi que l'analyse de la forme des signaux émis ne sont pas envisageables.

Pour ce qui est des techniques actuelles de mesure en durcissement, c'est à dire les techniques qui visent à analyser les signaux "utiles" émis par un appareil, à savoir les signaux non intentionnels contenant de l'information, on suppose jusqu'à présent que ces signaux sont connus a priori et l'on vérifie que leur niveau reste inférieur à des niveaux seuils. Aucune méthode de mesure en durcissement n'est actuellement spécifiée. En outre, les mesures actuelles ne permettent pas de donner un diagramme de rayonnement associé à un signal utile, ni de connaître la puissance totale rayonnée associée à ce signal. En ce sens, les mesures de. durcissement actuellement réalisées par les méthodes connues restent très incomplètes.

L'objectif de l'invention est de pallier ces différents inconvénients et limites des techniques connues.

Plus précisément, un premier objectif de l'invention est de fournir un procédé de mesure en champ proche permettant de mesurer dans ses conditions normales d'utilisation, et avec précision, toutes ses caractéristiques de rayonnement, y inclus la puissance rayonnée, le diagramme de rayonnement à toute distance, ainsi que la forme des signaux émis associée au diagramme de rayonnement de chacun de ces signaux.

Un autre objectif de l'invention est de mettre au point une technique de mesure qui soit capable d'utiliser la méthode théorique développée par les mêmes inventeurs, et mentionnée ci-dessus, dans un dispositif de complexité réduite permettant néanmoins d'acquérir les données nécessaires.

L'invention a également pour objectif de fournir une telle méthode de mesure qui soit exploitable avec des bases de mesure compactes, de faibles dimensions.

L'invention a enfin pour objectif de fournir un dispositif de mise en oeuvre d'un tel procédé.

Ces objectifs, ainsi que d'autres qui apparaîtront par la suite, sont atteints selon l'invention à l'aide d'un procédé de détermination des caractéristiques du rayonnement radioélectrique émis par un appareil, du type consistant à réaliser au moins une mesure de rayonnement dans le champ de rayonnement de l'appareil, caractérisé en ce qu'il consiste à effectuer une pluralité de jeux de mesures simultanées en champ proche, au sein d'une surface de mesure située à faible distance de l'appareil, et à appliquer une méthode d'estimation des propriétés statistiques des champs rayonnés en tout point extérieur, à la surface de mesure à partir desdits jeux de mesures effectués.

C'est en effet grâce à la réalisation de ces jeux de mesures simultanées en champ proche rayonné qu'il est possible de mettre en place un traitement numérique d'analyse de la forme des signaux émis, et de détermination de leur diagramme de rayonnement. Le traitement exploite avantageusement la méthode FBAB, qui permet la reconstruction de champs lointains utiles pour les études de Compatibilité Electromagnétique ou encore la téléphonie mobife. Cette méthode fait application des techniques de traitement des signaux mesurés sur les réseaux d'antennes aux problèmes de rayonnement en champ proche et est essentiellement un procédé d'estimation de la cohérence des signaux mesurés dans le domaine spatial pour réduire l'appareil mesuré de rayonnement inconnu à une combinaison équivalente de sources non cohérentes (en temps).

La méthode FBAB est mieux adaptée à la caractérisation des émissions des équipements électroniques du fait qu'elle fait l'hypothèse que les rayonnements mesurés sont constitués dé signaux stochastiques, et non de signaux déterministes. Elle permet en outre d'exploiter des dispositifs de mesure CP (champ proche) plus précis et de dimensions réduites.

Selon une autre caractéristique de l'invention, la réalisation de ladite pluralité de jeux de mesures simultanées consiste à déterminer un ensemble de points de mesure échantillonnant la surface de mesure, à choisir le nombre de points de mesure simultanée qui seront mesurés lors de chaque jeu de mesure (typiquement deux, pour former des couples de points de mesure, mais aussi le cas échéant 3 ou 4, ou davantage), et à réaliser des mesures successives sur toutes les combinaisons de jeux de points de mesure réalisables dans l'ensemble de points déterminé.

Selon une autre caractéristique importante de l'invention, la méthode inclut un pré-traitement de diminution de la complexité, consistant à :

- d'une part effectuer une première estimation des zones à fort rayonnement dans la surface de mesure ;
- puis à privilégier d'abord les mesures impliquant des points de mesure situés prioritairement dans lesdites zones à fort rayonnement ;
- et enfin à remplir ladite matrice d'espérance d'intercorrélation avec les premiers jeux de mesure en commençant par les points de mesure prioritaires, colonne par colonne, jusqu'à ce que la matrice devienne singulière. A ce moment, on peut considérer que l'ensemble des rayonnements possibles a été pris en compte, et que le processus de mesure est achevé. De ce fait, les matrices à manipuler pour déterminer la combinaison de sources non cohérentes équivalente au rayonnement de l'appareil mesuré sont alors beaucoup plus petites que les matrices carrées complètes (dans le cas où on a choisi d'effectuer des couples de mesures), et rendent donc le procédé réalisable.

Les caractéristiques de rayonnement déterminées par le procédé selon l'invention appartiennent avantageusement au groupe comprenant la puissance rayonnée par l'appareil, la forme des signaux émis, et le diagramme de rayonnement desdits signaux émis.

Selon une caractéristique avantageuse de l'invention, lesdits jeux de mesure simultanées sont réalisés à l'aide d'un nombre de capteurs au moins égal au nombre de mesures simultanées réalisées, lesdits capteurs permettant une mesure du champ rayonné selon au moins deux polarisations.

Selon une autre caractéristique de l'invention, ladite surface de mesure est générique et appartient au groupe comprenant les plans, les cylindres et les sphères), et lesdits capteurs assurant ladite mesure du champ rayonné permettent une mesure du champ selon deux polarisations.

En revanche, lorsque la surface de mesure n'est pas générique, lesdits capteurs assurant ladite mesure du champ rayonné doivent alors permettre une mesure du champ selon trois polarisations.

Avantageusement, lesdits capteurs appartiennent au groupe comprenant les antennes à fort taux de découplage en polarisation, et les capteurs « actifs ».

De façon préférentielle, lesdits jeux de mesures simultanés sont constitués de couples de mesures simultanées, mais ils peuvent aussi être constitués de nombres de mesures simultanées supérieures à deux, tels que des triplets et des quadruplets de mesures simultanées.

Egalement avantageusement, la distance de mesure proche est de quelques mètres au maximum, préférentiellement de l'ordre de un mètre.

Lorsque cela est nécessaire pour établir des diagrammes de rayonnement complets, ladite surface de mesure enveloppe l'appareil.

L'invention concerne également un dispositif de mise en oeuvre du procédé tel que décrit précédemment.

Selon l'invention, un mode de réalisation préférentiel du dispositif comprend une première armature-support comprenant des moyens de réception d'un appareil à mesurer et une seconde armature-support mobile par rapport à la dite première armature-support, chacune des deux armatures-supports étant munie d'au moins un capteur de mesure.

Avantageusement, ladite première armature support recevant l'appareil à mesurer comprend un plateau tournant de réception dudit appareil, solidaire d'un bras support d'un capteur de mesure formant sonde de référence, l'ensemble étant mobile en rotation autour d'un axe de rotation vertical passant substantiellement par le centre dudit plateau tournant.

Ladite seconde armature support est alors avantageusement constituée par une arche fixe dont le profil intérieur décrit essentiellement une génératrice de la surface de mesure, typiquement un segment droit, ou un cercle centré sur la zone de positionnement dudit appareil à mesurer.

Cette arche fixe est munie d'une pluralité de capteurs répartis le long du profil circulaire intérieur de l'arche.

Selon une autre caractéristique avantageuse de l'invention, ladite première armature support comprend des moyens de débrayage du plateau tournant par rapport au bras support, de façon à permettre une rotation sur 360° dudit plateau tournant lorsque le bras support vient en butée contre ladite seconde armature support.

Pour leur part, lesdits capteurs sont avantageusement positionnés à une distance inférieure ou égale à environ un mètre de la zone de positionnement dudit appareil à mesurer.

Au moins certains desdits capteurs sont préférentiellement constitués chacun par une antenne dite « en croix de Jérusalem ».

Le procédé et le dispositif trouvent avantageusement à s'appliquer pour à la mesure du rayonnement d'appareils dont on ne contrôle pas l'alimentation.

Ces systèmes présentent en outre de nombreux avantages suivants en matière de mesures de compatibilité électromagnétique car, outre la diminution des coûts de fonctionnement :

- ils évitent toute troncature angulaire, et permettent d'établir un diagramme de rayonnement de l'AST à toute distance :

- il offrent de meilleures conditions de positionnement et de mise en oeuvre des mesures ;
- ils permettent une meilleure prévision des perturbations éventuelles dûes à l'AST grâce à une caractérisation statistique des signaux émis par l'AST selon les directions angulaires ;
- ils permettent de pallier l'influence de l'environnement, ou tout au moins une meilleure prise en compte de cette influence.

Enfin, ces systèmes autorisent la conduite de mesures de durcissement à partir de l'analyse des signaux mesurés, et permettent les études d'interaction des ondes avec les personnes du fait de la connaissance du diagramme de rayonnement à très faible distance de l'appareil mesuré.

D'autres caractéristiques et avantages de l'invention apparaîtront à la lecture de la description suivante d'un mode de réalisation préférentiel de l'invention, à titre illustratif et non limitatif, et des dessins annexés, dans lesquels :

- la figure 1 est une vue de côté d'un dispositif de mesure selon l'invention ;
- la figure 2 est une vue de dessus du dispositif de la figure 1.

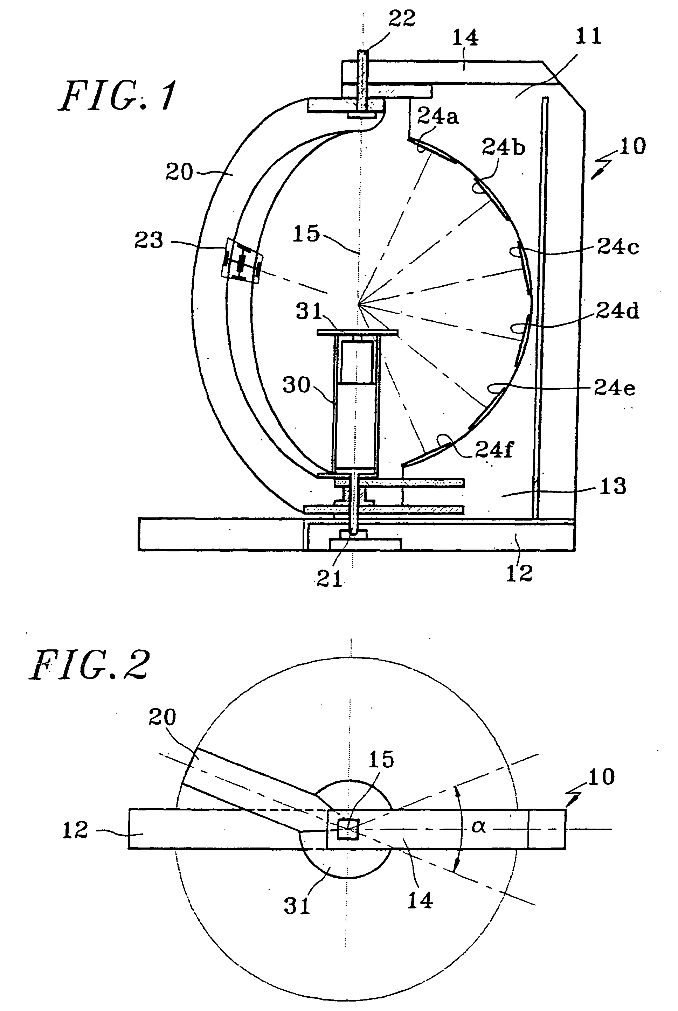

Le dispositif représenté aux figures 1 et 2 est un positionneur sphérique original permettant de recueillir l'ensemble des données nécessaires à la mise en oeuvre du procédé de mesure de l'invention, et du traitement de donnée associé. Il est particulièrement adapté pour réaliser des mesures sur des équipements de radiotéléphone mobile à 900 ou 1800 MHz.

Ce dispositif est constitué d'une armature support fixe 10 comprenant une arche 11 montée sur un socle 12. Entre les branches inférieure 13 et supérieure 14 de l'arche est installée une seconde armature support 20 qui est montée pivotante autour de pivots 21, 22. Cette armature support 20 pivotante forme un bras incurvé normalement solidaire d'un plateau tournant 30 réglable en hauteur et comprenant une plate-forme 31 de réception de l'appareil à analyser (AST, non représenté). Le bras 20 et le plateau 30 peuvent néanmoins être désolidarisés l'un de l'autre par débrayage.

Comme on peut le constater en vue de dessus (figure 2), le bras mobile 20 est en mesure de parcourir une course sur pratiquement 360° autour de l'axe de rotation 15. Toutefois, dans une zone angulaire ( à proximité immédiate de l'arche 11 de l'armature fixe 10, le bras 20 vient en butée contre l'arche 11. A ce moment, il est alors possible de permettre au plateau 30 de terminer une course complète à 360°, en le débrayant du bras mobile 20.

Le bras mobile 20 est équipé d'un capteur 23, constitué par une antenne formant sonde de référence, attachée à l'AST.

L'arche fixe 11 comprend elle-même un certain nombre de capteurs 24, à savoir 6 capteurs 24a-24f en l'occurrence.

La forme circulaire du profil intérieur du bras pivotant 20, comme de l'arche fixe 11, permet au plateau tournant, et donc à l'AST, de se situer au centre d'une sphère décrite par le mouvement relative des capteurs 24a-f par rapport au plateau tournant 30. En l'occurrence le rayon de la sphère est inférieur à un mètre, par exemple de l'ordre de 800 mm.

Ce même dispositif pourrait aussi être adapté, par exemple, pour former un positionneur cylindrique. Dans cet autre mode de réalisation (non représenté), le bras pivotant 20 comme le montant fixe 11 peuvent présenter un profil droit (au lieu du profil circulaire du mode de réalisation des figures 1 et 2). Le déplacement du plateau tournant 30 et du bras mobile 20 par rapport au montant fixe 11 génère une surface de mesure cylindrique qui permet l'établissement d'un diagramme de rayonnement satisfaisant si on peut négliger l'angle sous lequel l'appareil sous test voit les faces d'extrémité du cylindre de mesure.

Le positionneur sphérique est entièrement réalisé en matériau non invasif pour les ondes radioélectriques. par exemple en PVC.

Le rayonnement de l'AST est mesuré en deux points de la sphère simultanément, et ceci pour l'ensemble des couples de point jugés utiles.

Les capteurs 23 d'une part et 24a-f d'autre part permettent la prise des couples de mesures. une première mesure de chaque couple étant prise par l'une des antennes 24a-f, et l'autre étant effectuée par l'antenne de référence 23.

Pour les positions où le bras mobile 20 est désolidarisé du plateau 30. c'est l'une des antennes 24a-f de l'arche fixe 11 qui sert de capteur de référence.

Le nombre de capteurs 24 retenu peut être choisi en fonction des objectifs et notamment en fonction de la taille de l'AST ainsi que de la fréquence et de la précision de mesure recherchées.

Le champ émis par l'AST doit être mesuré en un certain nombre de points, qui constituent autant d'échantillons de la surface de mesure proche de l'AST, en l'occurrence la sphère décrite par les capteurs par rapport à l'AST. Le positionneur sphérique permettant des mesures sur 360°, il est alors possible de réaliser un diagramme de rayonnement total de l'appareil mesuré.

Le nombre de capteurs conditionne également la durée de la phase de mesure. Dans le mode de réalisation représenté, il a été choisi d'effectuer 6 mesures pour chaque position de l'AST, ce qui a amené à positionner les 6 antennes de mesure 24a-f sur l'arche fixe.

La sphère décrite par l'appareil étant une surface générique, on peut donc ne mesurer que deux polarisations des signaux, suivant les parallèles de la sphère d'une part et les méridiens d'autre part.

Les capteurs-antennes utilisés dans le dispositif de l'invention, en ce qui concerne tant le capteur de référence que les antennes positionnés sur l'arche fixe, sont avantageusement du type décrit dans la demande de brevet conjointe intitulée "Antenne imprimée bi-polarisation et réseau d'antennes correspondant", qui est incorporé ici par référence. Dans ce mode de réalisation préférentiel. ces antennes sont constituées de la combinaison de deux doubles dipôles, ce qui leur donne une allure de croix de Jérusalem. Chacun des doubles dipôles est imprimé sur une face du substrat de l'antenne, et mesure une polarisation de l'onde incidente (polarisation suivant un méridien ou polarisation suivant un parallèle). Le taux d'isolation en polarisation croisée entre les deux couples de dipôles est avantageusement de l'ordre de 40 dB à 900 MHz.

Chaque antenne étant constituée par un couple de dipôle, et comprenant de ce fait 2 sorties, le dispositif comporte 14 sorties.

La décomposition en modes sphériques de ce type d'antenne est connu, ce qui permet de réaliser une correction de sonde, et de se ramener précisément au champ électrique incident sur la structure.

Mais il est également possible d'utiliser d'autres types d'antennes compatibles avec le type de mesures réalisées, comme par exemple des capteurs « actifs » (typiquement des capteurs de champ) qui présentent une sensibilité accrûe pour un même encombrement spatial.

Le procédé de l'invention comprend une phase d'acquisition des mesures, et une phase de traitement des signaux mesurés.

Pour ce qui est de la phase d'acquisition des mesures, il faut tout d'abord déterminer un ensemble de points de mesure échantillonnant la surface de mesure, puis choisir le nombre de points de mesure simultanée qui seront mesurés lors de chaque jeu de mesure, et à réaliser des mesures successives sur toutes les combinaisons de jeux de points de mesure réalisables dans l'ensemble de points déterminé. En l'occurrence, si l'ensemble de points échantillonnant la surface de mesure comprend 72 points, et si on choisit d'effectuer des couples de mesures simultanées, on devra effectuer 72x72 = $72^2$ jeux de mesures, dont les résultats seront fournis à une matrice d'espérance d'intercorrélation comprenant 72 lignes et 72 colonnes.

L'acquisition simultanée de deux signaux, à chaque couple de mesures simultanées, peut être effectuée en utilisant une matrice de commutation. Les câbles reliant les sorties des antennes avec la matrice de commutation devront avoir une même longueur afin que le délai de propagation soit le même pour tous les signaux. L'isolation entre voies dans la matrice doit être supérieure à 40 dB.

Les appareils d'acquisition doivent permettre d'échantillonner les signaux provenant de la matrice. Cet échantillonnage peut être réalisé directement, par exemple par oscilloscope rapide, ou après transposition du signal à une fréquence intermédiaire à l'aide d'un analyseur de signaux vectoriels par exemple.

La méthode FBAB va maintenant être décrite, en relation avec la publication précitée décrivant cette méthode.

Comme déjà indiqué, le traitement du signal mis en oeuvre dans le cadre de l'invention est compatible avec le comportement temporel imprévisible et aléatoire des signaux émis par les appareils électroniques à étudier. Les rayonnements captés sont filtrés afin de les ramener à des signaux en bande étroite. Le champ total mesuré sur la surface de mesure est décomposé en la somme des rayonnements de sources équivalentes à bande étroite alimentées par des signaux faiblement stationnaires et parfaitement décorrélés deux à deux. Cette décomposition permet de calculer les propriétés statistiques du champ total en tout point extérieur à la surface de mesure.

Si on suppose que la surface de mesure est sphérique, le champ complexe bande étroite E (M, $f_0$,t) rayonné par un équipement électronique au point M peut s'écrire :

$$\vec{E}(M,f_0,t) = \vec{E}_{harm}(M,f_0).z(t)$$

où $\vec{E}_{harm}(M,f_0)$ serait le champ rayonné par cet équipement s'il était alimenté par une porteuse normalisée en amplitude à la fréquence $f_0$, et z(t) est un processus stochastique stationnaire complexe qui tient compte du caractère aléatoire des émissions.

Tout se passe comme si le champ à la fréquence porteuse $f_0$ était modulé par le signal en bande de base z(t).

Le champ en chaque point de mesure résulte de l'addition des rayonnements de sources équivalentes décorrélées. Afin de reconstruire les champs proches rayonnés par chacune de ces sources, on cherche à déterminer la cohérence des signaux aux différents points de mesure, au cours du temps et à la fréquence $f_0$. Pour cela on s'intéresse à la fonction de densité spectrale conjointe ou interspectre. Pour deux signaux réels mesuré en deux points K et L de la surface de mesure, sk(t,T) et sl(t,T), de signaux de bande de base associés zk(t, $f_0$) et zl(t, $f_0$), la fonction d'interspectre à la fréquence $f_0$, $G_{k,l}(f_0)$, généralement complexe, est définie par :

$$G_{k,l}(f_0) = \lim_{\Delta f \to 0} \lim_{T \to \infty} \frac{1}{T\Delta f} \int_0^T z_k(t,f_0) z_l^*(t,f_0)\,dt$$

L'exposant * désigne le complexe conjugué. En mesurant les champs émis simultanément pour tous les couples de points de la surface pour un nombre fini 1 d'échantillons temporels, on peut former la matrice G d'espérance d'intercorrélation, de terme général :

$$G(k,l) = \left[ E\left\{ G_{kl}(f_0,i) \right\}_{i \in [1,l]} \right]$$

G est une matrice hermitienne qui peut se décomposer sous la forme G = USU$^T$ , où S est la matrice diagonale des valeurs singulières de G, et U la matrice des vecteurs singuliers de G. Le nombre p (p $\leq$ N) de valeurs singulières dominantes de G est égal au nombre de sources équivalentes. Les p premiers vecteurs colonnes de U forment le sous espace du signal ; les N-p restants forment le sous espace de bruit. Le vecteur colonne U$_k$, (1 $\leq$ k $\leq$ p), représente le diagramme de rayonnement en champ proche de la k-ième source équivalente. Ce diagramme en champ proche est normalisé car on a $\|U_k\|$ = 1. Les p plus grandes valeurs singulières sont les valeurs quadratiques moyennes des signaux d'alimentation des différentes sources.

La phase de traitement des signaux de mesure acquis comprend avantageusement une étape préalable de traitement préalable des données de mesure avant la mise en oeuvre de la méthode FBAB.

Les données mesurées sont en effet préférentiellement prétraitées afin de diminuer la complexité de la mesure, et ainsi diminuer de façon importante la durée de mesure d'un AST. Ce traitement préalable est avantageusement réalisé au cours de la procédure de mesure

Le pré-traitement est réalisé de la façon suivante.

On effectue tout d'abord une première estimation des zones à fort rayonnement dans la surface de mesure, en réalisant les mesures en amplitude seulement dans un premier temps dans le but de privilégier d'abord les mesures impliquant des points de mesure situés prioritairement dans lesdites zones à fort rayonnement.

Le capteur-antenne de référence est alors positionné dans les zones de fort rayonnement pour procéder aux mesures complètes. Pour chaque position de l'antenne de référence, on remplit une nouvelle colonne de la matrice d'intercorrélation, mentionnée ci-dessus dans la description de la méthode FBAB. Le rang de la nouvelle matrice est estimé. Lorsque la matrice devient singulière à l'adjonction d'une nouvelle colonne, l'ensemble des rayonnements possibles a été pris en compte et le processus de mesure peut être arrêté.

C'est cette étape de pré-traitement qui permet une très grande diminution de la quantité de mesures nécessaires, et qui rend possible l'utilisation du dispositif de l'invention.

## Revendications

**1.** Procédé de détermination des caractéristiques du rayonnement radioélectrique émis par un appareil, du type consistant à réaliser au moins une mesure de rayonnement dans le champ de rayonnement de l'appareil, consistant à effectuer une pluralité de mesures en champ proche, au sein d'une surface de mesure située à faible distance de l'appareil, **caractérisé en ce qu'**on effectue une pluralité de jeux de mesures simultanées, et **en ce qu'**on applique une méthode de traitement desdits jeux de mesures effectués consistant à estimer les propriétés statistiques des champs rayonnés en tout point extérieur à la surface de mesure.

**2.** Procédé selon la revendication 1, **caractérisé en ce que** la réalisation de ladite pluralité de jeux de mesures simultanées consiste à déterminer un ensemble de points de mesure échantillonnant la surface de mesure, à choisir le nombre de points de mesure simultanée qui seront mesurés lors de chaque jeu de mesures, et à réaliser des mesures successives sur toutes les combinaisons de jeux de points de mesure réalisables dans l'ensemble de points déterminé.

**3.** Procédé selon l'une quelconque des revendications 1 et 2, dans lequel ladite méthode de traitement comprend une phase de remplissage d'une matrice d'estimation d'intercorrélation permettant de fournir une estimation de la cohérence des signaux mesurés dans le domaine spatial afin de réduire le rayonnement mesuré à une combinaison équivalente de sources non cohérentes, **caractérisé en ce que** la méthode inclut un pré-traitement de diminution de la complexité, consistant à :

- d'une part effectuer une première estimation des zones à fort rayonnement dans la surface de mesure ;
- puis à privilégier d'abord les mesures impliquant des points de mesure situés prioritairement dans lesdites zones à fort rayonnement ;
- et enfin à remplir ladite matrice d'espérance d'intercorrélation avec les premiers jeux de mesure en commençant par les points de mesure prioritaires, colonne par colonne, en stoppant le processus lorsque la matrice devient singulière.

**4.** Procédé selon l'une quelconque des revendications 1 à 3, **caractérisé en ce que** lesdits jeux de mesure simultanées sont réalisés à l'aide d'un nombre de capteurs au moins égal au nombre de mesures simultanées réalisées, lesdits capteurs permettant une mesure du champ rayonné selon au moins deux polarisations.

**5.** Procédé selon l'une quelconque des revendications 1 à 4, **caractérisé en ce que** ladite surface de mesure est générique et appartient au groupe comprenant les plans, les cylindres et les sphères), et **en ce que** lesdits capteurs assurant ladite mesure du champ rayonné permettent une mesure du champ selon deux polarisations.

**6.** Procédé selon l'une quelconque des revendications 1 à 5, **caractérisé en ce que** lesdits capteurs assurant ladite mesure du champ rayonné permettent une mesure du champ selon trois polarisations.

**7.** Procédé selon l'une quelconque des revendications 1 à 6, **caractérisé en ce que** lesdits capteurs appartiennent au groupe comprenant les antennes à fort taux de découplage en polarisation, et les capteurs « actifs ».

8. Procédé selon l'une quelconque des revendications 1 à 7 **caractérisé en ce que** lesdits jeux de mesures simultanés sont constitués de couples de mesures simultanées.

9. Procédé selon l'une quelconque des revendications 1 à 8 **caractérisé en ce que** lesdits jeux de mesures simultanés sont constitués de nombres de mesures simultanées supérieures à deux, tels que des triplets et des quadruplets de mesures simultanées.

10. Procédé selon l'une quelconque des revendications 1 à 9 **caractérisé en ce que** ladite méthode d'estimation des propriétés statistiques des champs rayonnés en tout point extérieur à la surface de mesure est une méthode de traitement des données de type méthode FBAB.

11. Procédé selon l'une quelconque des revendications 1 à 10 **caractérisé en ce que** la distance de mesure proche est de quelques mètres au maximum, préférentiellement de l'ordre de un mètre.

12. Procédé selon l'une quelconque des revendications 1 à 11 **caractérisé en ce que** ladite surface de mesure enveloppe l'appareil.

13. Procédé selon l'une quelconque des revendications 1 à 12 **caractérisé en ce que** lesdites caractéristiques de rayonnement appartiennent au groupe comprenant la puissance rayonnée par l'appareil, la forme des signaux émis, et le diagramme de rayonnement desdits signaux émis.

14. Dispositif de détermination des caractéristiques du rayonnement radioélectrique émis par un appareil, du type consistant à réaliser au moins une mesure de rayonnement dans le champ de rayonnement de l'appareil, au sein d'une surface de mesure située à faible distance de l'appareil, **caractérisé en ce qu'**il comprend :

   - des moyens pour effectuer une pluralité de mesures simultanées en champ proche, au sein de ladite surface de mesure ; et
   - des moyens de traitement desdits jeux de mesures effectués mettant en oeuvre des moyens d'estimation des propriétés statistiques des champs rayonnés en tout point extérieur à la surface de mesure.

15. Dispositif selon la revendication 14 **caractérisé en ce qu'**il comprend une première armature-support (20) comprenant des moyens de réception (30) d'un appareil à mesurer et une seconde armature-support (10) mobile relativement à la dite première armature-support (20), chacune des deux armatures-supports (10, 20) étant munie d'au moins un capteur de mesure (23, 24).

16. Dispositif selon l'une quelconque des revendications 14 et 15, **caractérisé en ce que** ladite première armature support (20) recevant l'appareil à mesurer comprend une plate-forme (31) de réception dudit appareil, solidaire d'un bras support d'un capteur de mesure (23) formant sonde de référence, l'ensemble étant mobile en rotation autour d'un axe de rotation vertical passant substantiellement par le centre dudit plateau tournant.

17. Dispositif selon l'une quelconque des revendications 14 à 16, **caractérisé en ce que** ladite seconde armature support (10) est constituée par une arche fixe (11) dont le profil intérieur décrit essentiellement une génératrice de la surface de mesure, typiquement un segment droit ou un cercle centré sur la zone de positionnement dudit appareil à mesurer.

18. Dispositif selon l'une quelconque des revendications 14 à 17, **caractérisé en ce que** ladite arche fixe (11) est munie d'une pluralité de capteurs (24a-f) répartis le long du profil circulaire intérieur de l'arche (11).

19. Dispositif selon l'une quelconque des revendications 14 à 18, **caractérisé en ce que** ladite première armature support (20) comprend des moyens de débrayage du plateau tournant (30) par rapport au bras support, de façon à permettre une rotation sur 360° dudit plateau tournant (30) lorsque le bras support vient en butée contre ladite seconde armature support (10).

20. Dispositif selon l'une quelconque des revendications 14 à 19, **caractérisé en ce que** lesdits capteurs (23, 24a-f) sont positionnés à une distance inférieure ou égale à environ un mètre de la zone de positionnement (31) dudit appareil à mesurer.

21. Dispositif selon l'une quelconque des revendications 14 à 20, **caractérisé en ce qu'**au moins certains desdits capteurs (23, 24a-f) sont constitués chacun par une antenne dite « en croix de Jérusalem »

22. Application du procédé et du dispositif selon l'une quelconque des revendications précédentes à la mesure du rayonnement d'appareils dont on ne contrôle pas l'alimentation.

**Patentansprüche**

1. Verfahren zum Bestimmen der Eigenschaften der von einem Gerät abgegebenen elektromagnetischen Strahlung, von der Art, bei der mindestens eine Strahlungsmessung im Strahlungsfeld des Gerätes durchgeführt wird, welches im Durchführen einer Vielzahl von Nahfeldmessungen innerhalb einer in der Nähe des Gerätes befindlichen Messfläche besteht,
**dadurch gekennzeichnet, dass** man eine Vielzahl von Sätzen gleichzeitiger Messungen durchführt und, dass eine Methode zum Verarbeiten dieser Messungssätze angewandt wird, bei der die statistischen Eigenschaften der an jedem Punkt außerhalb der Messfläche bestrahlten Felder geschätzt werden.

2. Verfahren nach Anspruch 1, **dadurch gekennzeichnet, dass** die Ausführung der Vielzahl von Sätzen gleichzeitiger Messungen im Feststellen einer Menge von Messpunkten besteht, welche die Messfläche abtasten, im Wählen der Zahl der bei einem jeden Messungssatz gleichzeitig gemessenen Messpunkte und im Durchführen von aufeinander folgenden Messungen über alle Kombinationen von Messpunktsätzen, die innerhalb der festgestellten Punktmenge durchführbar sind.

3. Verfahren nach einem der Ansprüche 1 oder 2, bei dem die Verarbeitungsmethode eine Phase zum Füllen einer Interkorrelierungs-Schätzungsmatrix umfasst, welche das Liefern einer Schätzung der Kohärenz der räumlich gemessenen Signale ermöglicht, um die gemessene Strahlung auf eine gleichwertige Kombination nicht kohärenter Quellen zu reduzieren, **dadurch gekennzeichnet, dass** die Methode eine Vorbehandlung zum Verringern der Komplexität aufweist, welche darin besteht:

   • einerseits im Ausführen einer ersten Schätzung der Bereiche starker Strahlung innerhalb der Messfläche;
   • danach, zuerst im Bevorzugen der Messungen, welche vorrangig in den Bereichen starker Strahlung liegende Messpunkte implizieren und,
   • zuletzt im Füllen der Interkorrelations-Erwartungsmatrix mit den ersten Messungssätzen, angefangen mit den vorrangigen Messpunkten, Spalte für Spalte, wobei das Verfahren angehalten wird, wenn die Matrix singulär wird.

4. Verfahren nach einem der Ansprüche 1 bis 3, **dadurch gekennzeichnet, dass** die Sätze gleichzeitiger Messungen mit Hilfe einer mindestens der Zahl der durchgeführten gleichzeitigen Messungen gleichen Zahl von Fühlern durchgeführt werden, wobei diese Fühler das Messen des bestrahlten Feldes nach mindestens zwei Polarisationen ermöglichen.

5. Verfahren nach einem der Ansprüche 1 bis 4, **dadurch gekennzeichnet, dass** die Messfläche generisch ist und der Gruppe angehört, welche Ebenen, Zylinder und Kugeln umfasst und, dass die Fühler, welche das Messen der bestrahlten Felder sicherstellen, eine Feldmessung nach zwei Polarisationen ermöglichen.

6. Verfahren nach einem der Ansprüche 1 bis 5, **dadurch gekennzeichnet, dass** die Fühler zum Messen des bestrahlten Feldes eine Feldmessung nach drei Polarisationen ermöglichen.

7. Verfahren nach einem der Ansprüche 1 bis 6, **dadurch gekennzeichnet, dass** die Fühler der Gruppe der Antennen mit starker Polarisierungsentkopplung sowie der "aktiven" Fühler angehören.

8. Verfahren nach einem der Ansprüche 1 bis 7, **dadurch gekennzeichnet, dass** die Sätze gleichzeitiger Messungen aus paarweise gleichzeitigen Messungen bestehen.

9. Verfahren nach einem der Ansprüche 1 bis 8, **dadurch gekennzeichnet, dass** die Sätze gleichzeitiger Messungen aus mehr als zwei gleichzeitigen Messungen bestehen, beispielsweise Gruppen von drei oder vier gleichzeitigen Messungen.

10. Verfahren nach einem der Ansprüche 1 bis 9, **dadurch gekennzeichnet, dass** die Methode zum Schätzen der statistischen Eigenschaften der bestrahlten Felder an jedem Punkt außerhalb der Messfläche eine Datenverarbeitungsmethode des Typs FBAB ist.

**11.** Verfahren nach einem der Ansprüche 1 bis 10 **dadurch gekennzeichnet, dass** die Nahmessungsentfernung höchstens einige Meter beträgt und bevorzugterweise in der Größenordnung von einem Meter liegt.

**12.** Verfahren nach einem der Ansprüche 1 bis 11, **dadurch gekennzeichnet, dass** die Messfläche das Gerät umhüllt.

**13.** Verfahren nach einem der Ansprüche 1 bis 12, **dadurch gekennzeichnet, dass** die Strahlungseigenschaften der Gruppe angehören, welche die vom Gerät abgegebene Strahlungsleistung, die Form der gesendeten Signale sowie das Strahlungsdiagramm dieser gesendeten Signale umfasst.

**14.** Verfahren zum Bestimmen der Eigenschaften der von einem Gerät abgegebenen elektromagnetischen Strahlung, von der Art, bei der mindestens eine Strahlungsmessung im Strahlungsfeld des Gerätes innerhalb einer in der Nähe des Gerätes befindlichen Messfläche durchgeführt wird, **dadurch gekennzeichnet, dass** es folgendes umfasst:

- Mittel zum Durchführen einer Vielzahl von gleichzeitigen Nahfeldmessungen innerhalb des erwähnten Messfeldes und,
- Mittel zum Verarbeiten dieser durchgeführten Messungssätze, die Mittel zum Schätzen der statistischen Eigenschaften der bestrahlten Felder an jedem Punkt außerhalb der Messfläche ermöglichen.

**15.** Vorrichtung nach Anspruch 14, **dadurch gekennzeichnet, dass** sie einen ersten Trägerrahmen (20), welches über Empfangsmittel (30) eines Messgerätes verfügt sowie einen zweiten, gegenüber dem ersten Trägerrahmen (20) beweglichen Trägerrahmen (10) umfasst, wobei jeder dieser Trägerrahmen (10, 20) mindestens einen Messfühler (23, 24) aufweist.

**16.** Vorrichtung nach einem der Ansprüche 14 oder 15, **dadurch gekennzeichnet, dass** der erste, das Messgerät tragende Trägerrahmen (20), eine Plattform (31) zum Aufnehmen dieses Messgerätes aufweist, die mit einem Tragarm eines eine Referenzsonde bildenden Messfühlers (23) verbunden ist, wobei die Gruppe drehbar um eine vertikale Drehachse, die im wesentlichen durch die Mitte der Drehplatte verläuft, angebracht ist.

**17.** Vorrichtung nach einem der Ansprüche 14 bis 16, **dadurch gekennzeichnet, dass** der zweite Trägerrahmen (10) aus einem festliegenden Bogen (11) gebildet wird, dessen inneres Profil im wesentlichen einer Erzeugenden der Messfläche entspricht, typischerweise ein gerades Segment oder ein auf dem Positionierungsbereich des besagten Messgerätes zentrierten Kreis.

**18.** Vorrichtung nach einem der Ansprüche 14 bis 17, **dadurch gekennzeichnet, dass** der festliegende Bogen (11) eine Vielzahl von Fühlern (24a-f) aufweist, die entlang des inneren kreisförmigen Bogenprofils verteilt sind.

**19.** Vorrichtung nach einem der Ansprüche 14 bis 18, **dadurch gekennzeichnet, dass** der erste Trägerrahmen (20) Mittel zum Freigeben der Drehscheibe (30) im Verhältnis zum Trägerarm aufweist, um eine Drehung dieser Drehscheibe (30) um 360° zu ermöglichen, wenn der Trägerarm an den Trägerrahmen (10) anstößt.

**20.** Vorrichtung nach einem der Ansprüche 14 bis 19, **dadurch gekennzeichnet, dass** die Fühler (23, 24a-f) in einer Entfernung von etwa einem Meter oder weniger des Positionierungsbereiches (31) des Messgerätes angebracht sind.

**21.** Vorrichtung nach einem der Ansprüche 14 bis 20, **dadurch gekennzeichnet, dass** mindestens einige der Fühler (23, 24a-f) jeweils aus einer Antenne des Typs "Jerusalemer Kreuz" gebildet werden.

**22.** Anwendung des Verfahrens und der Vorrichtung gemäß einem der vorhergehenden Ansprüche auf das Messen der Abstrahlung von Geräten, deren Versorgung man nicht beherrscht.

**Claims**

**1.** Method for determining the properties of the radio radiation which an apparatus emits, of the type consisting of making at least one radiation measurement in the radiation field of the apparatus, consisting of carrying out a plurality of near field measurements, within a measurement surface located at a short distance from the apparatus, **characterized in that** a plurality of sets of simultaneous near field measurements is carried out, and **in that** a method of processing said sets of carried-out measurements is applied, consisting of estimating the statistical properties of radiated fields at any point outside the measurement surface.

2. Method according to Claim 1, **characterized in that** the production of said plurality of sets of simultaneous measurements consists of determining a set of measurement points sampling the measurement surface, choosing the number of points for simultaneous measurement which will be measured for each set of measurements, and carrying out successive measurements on all the combinations of sets of measurement points which are possible in the determined set of points.

3. Method according to any one of Claims 1 and 2, in which said method of processing comprises a phase of filling an intercorrelation estimation matrix, making it possible to supply an estimate of the coherence of the signals measured in the spatial domain to reduce the measured radiation to an equivalent combination of non-coherent sources, , **characterized in that** the method includes preprocessing to reduce the complexity, consisting of:

— firstly, carrying out a first estimate of the high radiation zones in the measurement surface;

— then first giving priority to the measurements involving the measurement points which are located in priority in said high radiation zones;

— and finally filling said expected intercorrelation matrix with the first measurement sets, beginning with the priority measurement points, column by column, and stopping the process when the matrix becomes singular.

4. Method according to any one of Claims 1 to 3, **characterized in that** said sets of simultaneous measurements are carried out with the aid of a number of sensors equal at least to the number of simultaneous measurements carried out, said sensors allowing measurement of the radiated field according to at least two polarisations.

5. Method according to any one of Claims 1 to 4, **characterized in that** said measurement surface is generic and belongs to the group comprising planes, cylinders and spheres, and **in that** said sensors, which assure said measurement of the radiated field, allow measurement of the field according to two polarisations.

6. Method according to any one of Claims 1 to 5, **characterized in that** said sensors assuring said radiated field measurement allow field measurement according to three polarisations.

7. Method according to any one of Claims 1 to 6, **characterized in that** said sensors belong to the group comprising the aerials with a high rate of polarisation decoupling, and the "active" sensors.

8. Method according to any one of Claims 1 to 7, **characterized in that** said sets of simultaneous measurements consist of pairs of simultaneous measurements.

9. Method according to any one of Claims 1 to 8, **characterized in that** said sets of simultaneous measurements consist of numbers of simultaneous measurements greater than two, such as triplets and quadruplets of simultaneous measurements.

10. Method according to any one of Claims 1 to 9, **characterized in that** said method of estimating the statistical properties of radiated fields at any point outside the measurement surface is a data processing method of FBAB type.

11. Method according to any one of Claims 1 to 10, **characterized in that** the distance of near measurement is a maximum of several metres, preferably of the order of one metre.

12. Method according to any one of Claims 1 to 11, **characterized in that** said measurement surface envelops the apparatus.

13. Method according to any one of Claims 1 to 12, **characterized in that** said radiation characteristics belong to the group comprising the power radiated by the apparatus, the shape of the emitted signals, and the radiation diagram of said emitted signals.

14. Device for determining the properties of the radio radiation which an apparatus emits, of the type consisting of making at least one radiation measurement in the radiation field of the apparatus, within a measurement surface located at a short distance from the apparatus, **characterized in that** it comprises:

   - means for carrying out a plurality of simultaneous near field measurements within said measurement surface; and

   - means for processing said sets of carried-out measurements, implementing means of estimating the statistical properties of radiated fields at any point outside the measurement surface.

15. Device according to Claim 14, **characterized in that** it comprises a first support frame (20) comprising means (30) for receiving an apparatus to be measured, and a second support frame (10) which is mobile relative to said first support frame (20), each of the two support frames (10, 20) being equipped with at least one measuring sensor (23, 24).

16. Device according to any one of Claims 14 and 15, **characterized in that** said first support frame (20) receiving the apparatus to be measured comprises a platform (31) for receiving said apparatus, integral with a support arm for a measuring sensor (23) forming a reference probe, the whole being mobile in rotation around a vertical rotation axis passing substantially through the centre of said rotating plate.

17. Device according to any one of Claims 14 to 16, **characterized in that** said second support frame (10) consists of a fixed arch (11) of which the internal profile essentially describes a generatrix of the measurement surface, typically a right angle segment, or a circle centred on the positioning zone of said apparatus to be measured.

18. Device according to any one of Claims 14 to 17, **characterized in that** said fixed arch (11) is equipped with a plurality of sensors (24a-f) arranged along the internal circular profile of the arch (11).

19. Device according to any one of Claims 14 to 18, **characterized in that** said first support frame (20) comprises means for disengaging from the rotating plate (30) relative to the support arm, in such a way as to allow rotation by 360° of said rotating plate (30) when the support arm comes to a stop against said second support frame (10).

20. Device according to any one of Claims 14 to 19, **characterized in that** said sensors (23, 24a-f) are positioned at a distance less than or equal to about one metre from the positioning zone (31) of said apparatus to be measured.

21. Device according to any one of Claims 14 to 20, **characterized in that** at least some of said sensors (23, 24a-f) consist of so-called "Jerusalem cross" aerials.

22. Application of the method and device according to any one of the preceding claims to measurement of the radiation of apparatus of which the supply is not controlled.

*FIG.1*

*FIG.2*